Europäisches Patentamt

European Patent Office

Office européen des brevets

(11) Publication number: **0 218 334 B1**

# EUROPEAN PATENT SPECIFICATION

(45) Date of publication of patent specification: **02.01.92** (51) Int. Cl.⁵: **G01R 31/26**

(21) Application number: **86306255.0**

(22) Date of filing: **13.08.86**

(54) Measuring method of a transistor.

(30) Priority: **13.08.85 JP 179645/85**

(43) Date of publication of application:
**15.04.87 Bulletin 87/16**

(45) Publication of the grant of the patent:
**02.01.92 Bulletin 92/01**

(84) Designated Contracting States:
**DE FR GB**

(56) References cited:
**JP-A-60 115 874**

**IBM TECHNICAL DISCLOSURE BULLETIN, vol. 23, no. 7A, December 1980, pages 2800-2802; W.E. RADCLIFFE "ICEX Test circuit for discrete transistors"**

**FUNK-TECHNIK, no. 1, 1972, pages 15-18; "Prüfverfahren zur zerstörungsfreien Untersuchung des Second Breakdown bei Leistungstransistoren"**

**Power Transistors Application Note AN-6866, RCA pages 534 to 539, February 1980**

**Power Transistors Application Note AN-6624, RCA pages 299 to 314, March 1978**

(73) Proprietor: **MITSUBISHI DENKI KABUSHIKI KAISHA**
**2-3, Marunouchi 2-chome Chiyoda-ku Tokyo 100(JP)**

(72) Inventor: **Takata, Ikunori c/o Mitsubishi Denki Kabushiki Kaisha Kitaitami Seisakusho 1 Mizuhara 4-chome Itami-shi Hyogo-ken(JP)**

(74) Representative: **Beresford, Keith Denis Lewis et al BERESFORD & Co. 2-5 Warwick Court High Holborn London WC1R 5DJ(GB)**

EP 0 218 334 B1

## Description

The present invention relates to a method of measuring values of voltage and corresponding current for a transistor. More particularly, the present invention relates to a measuring method of a transistor by which means the high-voltage operation withstand voltage and corresponding breakdown current of the transistor can be determined precisely.

In using a power transistor, failure due to secondary breakdown is a serious problem. Such secondary breakdown phenomena occur most frequently during voltage increase. Therefore, for a user of a transistor, it is desirable that the withstand voltage rating be prescribed by using the resistance to breakdown of the transistor as an index.

The withstand voltage of a transistor has been represented by a collector-to-base breakdown voltage (hereinafter referred to as $BV_{CBO}$), by a collector-to-emitter breakdown voltage measured with the base open-circuit (hereinafter referred to as $BV_{CEO}$), or by a collector-to-emitter sustaining voltage measured with the base open-circuit (hereinafter referred to as $V_{CEO}(sus)$). In practice, either $BV_{CEO}$ or $V_{CEO}(sus)$ is adopted as index of the upper limit voltage.

However with the advent of transistors having high withstand voltage and large capacitance, there has been a recent tendency to adopt a collector-to-emitter sustaining voltage measured with a reverse bias applied to the base (hereinafter referred to as $V_{CEX}(sus)$), as the appropriate withstand voltage rating.

For the above described withstand voltage rating, $BV_{CBO}$ and $BV_{CEO}$ are values measured with a collector current of the order of mA and $V_{CEX}(sus)$ and $V_{CEO}(sus)$ are values measured with a collector current value of approximately 1A. Since these collector current values are almost constant over the range of the capacitance of a transistor from 10A to 400A, little consideration is ever given to any relationship between collector current values and resistance to breakdown.

Therefore, the upper limit voltage in using a transistor should be regarded as the maximum compensation voltage in the safe operating area, not as the rated withstand voltage. However, it is difficult to determine the surface area for high voltage operation even if a large number of sample transistors are broken in tests conducted for that purpose.

A method for measuring $V_{CEO}(sus)$ is disclosed for example in JP-A-60-115 874 as a "Transistor ASO Test Method". This method evaluates the resistance to breakdown of a transistor in a non destructive manner making use of the fact that collector-to-emitter voltage $V_{CE}$ or collector current

$I_C$ flags under relatively less severe conditions than the conditions causing a transistor to be broken. However, this method lacks a viewpoint of evaluating the breakdown resistance of a transistor per se. This reference is directed to the measurement of a part of the sustained voltage versus current characteristic $V_{CE}(sus)$ and a critical point on this characteristic, a breakaway point from which point the current and voltage would, if unchecked, follow a path to destruction. This is to be contrasted with the measurements made, as described hereinafter, which are directed to determine the voltage and current values at a terminal breakdown point, a point lying on the breakdown boundary of the safe operating area where it is intersected by the sustained voltage versus current characteristic of the tested transistor. As discussed below, this latter measurable is more meaningful as a practical index of the safe operating area of a transistor.

Japanese Patent Laying-Open Gazette No. 115875/1985 discloses a "Method of Measuring $V_{CE}(sus)$ of a Transistor". However, this method is only an improvement which serves to facilitate the measurement which was conventionally made visually using a synchroscope.

Mention is also made of the following two references: "Practical Aspects of Voltage Breakdown Testing of Power Transistors & Darlingtons" by B.J.J. Chenery, Power Transistors Application Note AN-6866, RCA, pages 534 to 539, February 1980; and "Voltage Limitations of Power Transistors" by W.P. Bennett, Power Transistors Application Note AN-6624, RCA, pages 299 to 314, March 1978. Both of these papers concern measurements made of sustained voltage versus current. Neither of these disclose the extension of measurements to the determination of the values of sustained voltage and corresponding current at a terminal breakdown point on such voltage v. current characteristics, nor do they indicate any significance of such a point as a safe operating area index.

In common with the method of measurement described in JP-A-60-115874, the method of this present invention consists in a method of measuring values of voltage and corresponding current for a transistor, which transistor exhibits a voltage self-limiting property and has accordingly a sustained voltage versus current characteristic, this characteristic extending downwards from a terminal breakdown point through a point of minimum voltage, this method comprising:
raising collector current to an elevated value;
causing collector-to-emitter voltage imposed on said transistor to increase until an initial sustained voltage on said characteristic is attained, which sustained voltage corresponds to a current of value higher than the current corresponding to that of a minimum voltage; and

repeatedly performing the above steps of raising and causing.

In accordance with the present invention, this method is characterised in that:
said steps of raising and causing are repeated, each time raising the collector current to a higher elevated value, until the values of sustained voltage and corresponding current at said terminal breakdown point are determined so as to determine thus a safe operating area parameter given by said values.

The method just described can be applied to the characterisation of a transistor the base of which can be either open circuit or reversely biassed.

Even in circumstances where the base is reversely biassed, the method just described may be performed using apparatus that does not include a clamp circuit connected between the collector and the emitter of the sample transistor.

Other measurements may be conducted during the performance of the method just described. Thus, for example, sustained voltage and current measurements may be made over a tail portion of the sustained voltage versus current characteristic of the sample transistor. The latter measurements are best performed, however, using apparatus that does indeed include a clamp circuit connected between the collector and the emitter of the sample transistor.

These and other features, aspects and advantages of the present invention will become more apparent from the following detailed description of the present invention when taken in conjunction with the accompanying drawings.

In the accompanying drawings:
Fig. 1 is a circuit diagram showing a measuring circuit for conducting a test in a high-voltage state of a transistor;
Fig. 2 is a graph depicting measured current and voltage data based on the withstand voltage rating of a conventional transistor and a safe operating area is illustrated;
Fig. 3 is a trace showing an example of measurement of $V_{CEX}(sus)$ of a transistor commercially available having voltage and current ratings of 1000V and 100A, respectively; and
Fig. 4 is a graph showing withstand voltage indices and breakdown resistance of a transistor to illustrate measurement made in accordance with the present invention.

In order that the present invention might be better understood, an embodiment thereof will now be described and particular reference will be made to the drawings. The description that follows is given by way of example only.

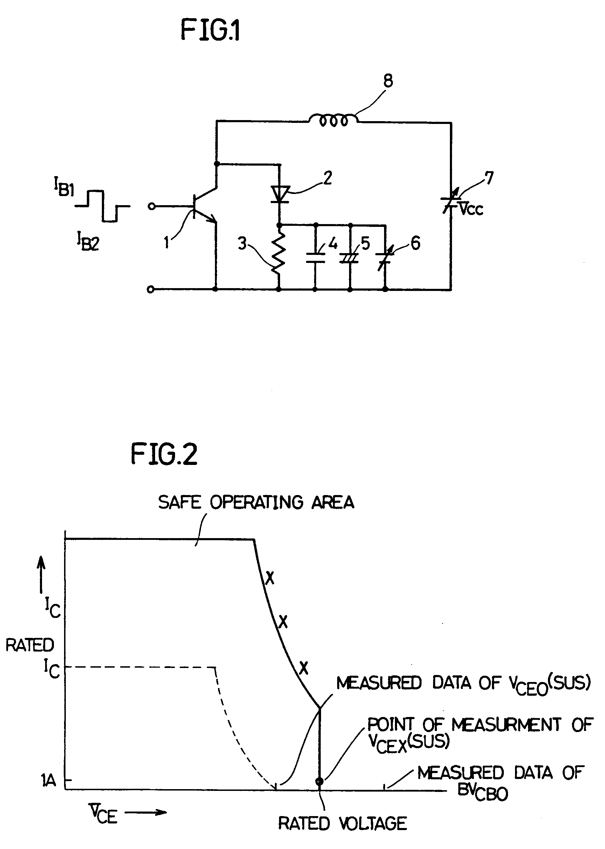

Fig. 1 is a diagram showing a measuring circuit that can be used for carrying out the method of this invention. Such a measuring circuit is shown in "A Basic Analysis of High Voltage Operation of High Power Transistors and Diodes" by I. Taketa et al, Conference Record of the IEEE IAS Annual Meeting October 6-11, 1985 pp 900-904. More specifically, in the measuring circuit shown in Fig. 1, a clamp circuit comprising a parallel circuit of a resistor 3, capacitors 4 and 5 and a clamp power supply 6 connected in series to a clamp diode 2 is connected between the collector and the emitter of a transistor 1, and a power supply 7 and a coil 8 for supplying main power supply voltage Vcc are connected in series between the collector and the emitter of the transistor 1. The clamp circuit operates so that the collector-to-emitter voltage ($V_{CE}$) of the transistor 1 shall not exceed the clamp voltage. A base amplifier, not shown, is connected to the base of the sample transistor 1.

When $V_{CEX}(sus)$ or reverse bias breakdown is measured in the measuring circuit constructed as described above, a forward base current pulse ($I_{B1}$), is applied, flows first and then a reverse base current pulse ($I_{B2}$), is applied, as shown in Fig. 1. At the time of measuring $V_{CEO}(sus)$, only forward base current $I_{B1}$ flows and reverse base current $I_{B2}$ is made 0. Collector voltage ($V_{CE}$) and collector current ($I_C$) of the sample transistor 1 depend not only on the conditions for actuating the base but also on the flowing time of $I_{B1}$, the inductance of the coil 8 and the magnitude of the main power supply voltage Vcc. The values of these are chosen as appropriate.

At the time of measuring $V_{CEX}(sus)$, the clamp voltage is set so that $V_{CE}$ of the sample transistor 1 shall not exceed the rated voltage, $V_{CEX}(sus)$. This is because it is known from experience that if $V_{CEX}(sus)$ is measured without connecting a clamp circuit, a voltage considerably larger than the rated value $V_{CEX}(sus)$, would be applied to the transistor 1, causing breakdown. Collector current at the time of measuring $V_{CEX}(sus)$ is controlled by the main power supply voltage Vcc but it does not much depend on the capacitance of the sample transistor 1 and has a value of approximately 1A.

It is known by experience that a clamp circuit is not necessarily needed for measurement of $V_{CEO}(sus)$. In measurement of $V_{CEO}(sus)$, $V_{CE}$ of the sample transistor 1 does not reach such a high voltage in the tail portion of the characteristic as to cause the transistor 1 to become unstable and to be broken prematurely. Thus, the state in which collector current flows stably with a high voltage determined by a transistor device per se being maintained is called sustaining operation. It has hitherto been thought that measurement of $V_{CEX}(sus)$ would always involve the possibility of premature breakdown, whereas measurement of $V_{CEO}(sus)$ is stable and there is little fear of premature breakdown. However, in the past, $V_{CEO}$(sus) has not been measured with collector currents higher than several amperes.

Fig. 2 is a diagram showing in combination, measured data in accordance with the present invention based on the withstand voltage rating of a conventional transistor and an example of a safe operating area. Referring to Fig. 2, the marks X represent breakdown points at the time of measurement of reverse bias breakdown and the dotted line represents an example of a safe operating area which was widely adopted several years ago. Referring to Fig. 2, collector current $I_C$ is often defined usually up to a value twice as large as the rated current. The safe operating area is determined dependent on two cases, that is, the case in which reverse bias is applied to the base and the case in which forward bias is applied to the base. It is an area defined by the curve connecting the inside portions of the breakdown points (X in Fig. 2) where the device is broken under a specified bias condition, the rated voltage value shown as $V_{CEX}$(sus) and the conduction compensation collector current value.

This safe operating area is determined in a complicated manner, dependent generally on the bias conditions and dependent on the time for applying electric power in the case of forward bias. However, practically, as a significant index for a utilizable upper limit voltage, the area in the state in which reverse bias is applied to the base is regarded as a typical safe operating area, in which high-voltage operation of a transistor is often made in practical use. The breakdown resistance in the reverse bias state of the base is also measured by the measuring circuit shown in Fig. 1.

As is clear from Fig. 2, a close relation of the safe operating area to $V_{CEX}$(sus) and $V_{CEO}$(sus) is not indicated particularly in the case of a device having rated current higher than dozens of amperes. Such lack of correspondence between the rated voltage of a transistor and the utilizable upper limit voltage in practical use is a natural result from the technical level of transistors in the past from a historical point of view. The safe operating area of a transistor applied several years ago was generally the area as shown by the dotted line in Fig. 2 and such a safe operating area was rarely indicated clearly. Transistors in those days were really broken extremely easily in an area of high voltage. In those days, transistors were said to be easy to handle as power devices but they were said to be very liable to be broken.

Since then, the characteristics of a transistor have been remarkably improved and as for the safe operating area for example, an improvement has been made such that collector current almost equal to rated current can be made to flow with rated voltage as shown in Fig. 2.

A clear explanation has not been made as to the mechanism by which such improvement of the characteristics of a transistor can be made. The present invention makes it possible to realise means for measuring simply and clearly the utilisable upper limit voltage of a transistor.

In measurement of $V_{CEX}$(sus), the clamp circuit in the measuring circuit shown in Fig. 1 can be omitted or the clamping function can be substantially obviated by making clamp voltage sufficiently high, whereby the voltage and the current determined by the capability of a device to be measured per se which could be observed in the measurement of $V_{CEO}$(sus) in the prior art can be readily measured.

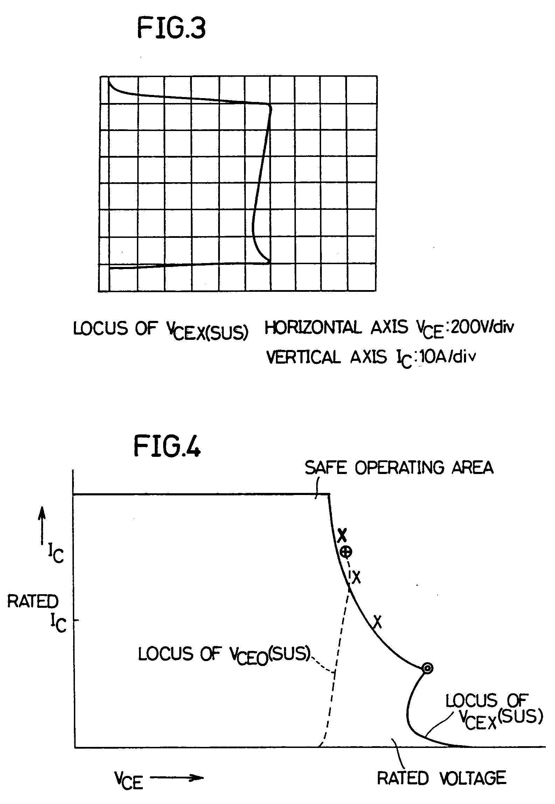

Fig. 3 is a diagram showing an example of measurement of $V_{CEX}$(sus) of a commercially available device of 1000V and 100A rating, the horizontal axis being selected to $V_{CE}$: 200V/div and the vertical axis being selected to $I_C$: 10A/div. As is clear from Fig. 3, collector current having a value of 60A larger than the half of the rated current flows with a voltage higher than the rated voltage and this measurement can be made repeatedly in an extremely stable manner. During this measurement, as collector current is increased by either a method of increasing main power supply voltage Vcc in the measuring circuit shown in Fig. 1 or a method of increasing the conduction width of forward base current ($I_{B1}$), a waveform as shown in Fig. 3 in which the voltage-current waveform is extended is obtained and terminal breakdown occurs before long (at the point where the voltage is maximum). This point is represented by the mark ◎ in Fig. 4.

This breakdown point exists on a line extended from the breakdown points shown by the marks X in Fig. 2 obtained by reverse bias breakdown testing. Fig. 4 shows loci of these breakdown points and $V_{CEX}$(sus). The locus of $V_{CEX}$(sus) changes dependent on the reverse bias condition of the base even in the measurement of the same sample devices (if reverse bias of the base is deep, it moves to the area of high voltage and if reverse bias of the base is shallow, it moves to the area of low voltage). However, it is ascertained that the locus of $V_{CEX}$(sus) is extremely stable and does not cause unstable operation nor breakdown if the electric current value is lower than a prescribed value. The previously cited document in the description of the prior art "A Basic Analysis of High Voltage Operation of High Power Transistors and Diodes" describes in a general manner experiments and analyses of high voltage operation of transistors as described above. In this document, it is indicated that a transistor has as an upper limit of high voltage, prescribed stable voltage and current characteristics determined by the base actuating conditions in a range where electric current is lower than a certain current value determined by the manufacturing method thereof.

In consequence, it can be understood that the locus of $V_{CEX}$(sus) of a transistor in a range of large current has an extremely important meaning as an index of the utilizable upper limit voltage (and current). More specifically, the upper limit current value enabling safe operation of a transistor changes dependent on the base actuating conditions, and the locus of this current value extends generally to a smaller degree as the voltage ($V_{CE}$) becomes high and terminates at a point of intersection with the locus of $V_{CEX}$(sus).

If electric current is smaller than the value at this terminal breakdown point, an operation point never exists outside the locus of $V_{CEX}$(sus) (on the side of high voltage) and the device will never be broken since the operation with $V_{CEX}$(sus) per se is a stable operation.

Fig. 4 is a diagram showing the withstand voltage characteristics and the breakdown reticence of a transistor. Referring to Fig. 4, the solid line represents a locus of $V_{CEX}$(sus); the point ⓞ represents a terminal breakdown point in the measurement of $V_{CEX}$(sus); the mark ⊕ represents a breakdown point in the measurement of $V_{CEO}$(sus); the points X represent points of measurement of reverse bias breakdown; and the dotted line represents an example of a locus of $V_{CEO}$(sus). The locus of $V_{CEX}$(sus) is curved toward the area of low voltage as is obvious from Fig. 3 and has a point of minimum voltage. When the electric current becomes smaller than the value at this point, the voltage starts to increase rapidly as shown in Fig. 4 and becomes somewhat higher than that at the point of minimum voltage, and can exceed it by several hundreds of volts, finally. Practically, in most devices, voltage does not increase so largely as to attain theoretical value. However, if $V_{CEX}$(sus) of a device having rated current of at least dozens of amperes is measured by a current of approximately 1A, it may happen that measurement is made in a wide range of the locus extending as much as hundreds of volts, resulting in measurement of a value higher than the substantially significant voltage at the terminal breakdown point on the locus of $V_{CEX}$(sus) (or the voltage at the point of voltage minimum).

As is clear from the foregoing description, the function of a clamp circuit is not required for measurement of $V_{CEX}$(sus). However, if reverse bias of the base has a large value, it is ascertained experimentally and theoretically that breakdown may occur at the leading edge of the extended range of the locus of $V_{CEX}$(sus). Therefore, it is practically useful to use a clamp circuit and to set the clamp voltage to a value higher than the measureable terminal breakdown voltage on the sustained voltage v. current locus of $V_{CEX}$(sus).

It is now clear that a transistor does not operate in an anomalous manner even in a condition of large current and high voltage involving possibility of breakdown and that the difference between $V_{CEO}$(sus) and $V_{CEX}$(sus) resides only in the difference in the base actuating conditions and not in any fundamental difference. From this viewpoint, a point causing breakdown by flowing a large current at the time of measurement of $V_{CEO}$(sus) can be regarded as an ultimate point where reverse current of the base is made to approximate to 0 at the time of measurement of reverse bias breakdown resistance.

Fig. 4 shows an example of a locus of $V_{CEO}$(sus) by the dotted line and shows by the mark ⊕ the breakdown point where breakdown occurs consistently in the same samples. It is indicated that the reverse bias breakdown resistance decreases as reverse base current becomes small, while it was ascertained that a current value of $V_{CEO}$(sus) compared by the same voltage is more approximate to the measured value of reverse bias breakdown resistance in the case of a small reverse bias current.

Consequently, it can be said that the breakdown point of $V_{CEO}$(sus) is good data for indicating the safe operating area of a transistor. In addition, a method of measuring the above stated breakdown point is simpler since parameters such as reverse base current are not used as compared with a method of measuring a breakdown point in reverse bias breakdown. In addition, the above stated breakdown point is preferred as an index and can be expected to exist on the extention of the locus of $V_{CEO}$(sus), and therefore, a method of measuring the above stated breakdown point can be said to be an easier measuring method. Furthermore, it can be said that it is possible to estimate the safe operating area of a transistor merely by observation of breakdown in $V_{CEX}$(sus) and $V_{CEO}$(sus).

Although the present invention has been described and illustrated in detail, it is clearly understood that the same is by way of illustration and example only and is not to be taken by way of limitation, the scope of the present invention being limited only by the terms of the appended claims.

**Claims**

1.   A method of measuring values of voltage and corresponding current for a transistor, which transistor exhibits a voltage self-limiting property and has accordingly a sustained voltage versus current characteristic, this characteristic extending downwards from a terminal breakdown point through a point of minimum voltage, this method comprising:

raising collector current to an elevated value;

causing collector-to-emitter voltage imposed on said transistor to increase until an initial sustained voltage on said characteristic is attained, which sustained voltage corresponds to a current of value higher than the current corresponding to that of a minimum voltage; and

repeatedly performing the above steps of raising and causing;

characterised in that:

said steps of raising and causing are repeated, each time raising the collector current to a higher elevated value, until the values of sustained voltage and corresponding current at said terminal breakdown point are determined so as to determine thus a safe operating area parameter given by said values.

2. The method as claimed in claim 1, wherein said steps of raising and causing are repeated until breakdown occurs at said terminal breakdown point.

3. The method as claimed in either one of the preceding claims, wherein said values of sustained voltage and corresponding current at said terminal breakdown point are determined for a transistor, the base of which is open.

4. The method as claimed in either claim 1 or 2, wherein said values of sustained voltage and corresponding current at said terminal breakdown point are determined for a transistor, the base of which is reverse biassed.

5. The method as claimed in claim 4, when performed with a clamp circuit connected between the collector and the emitter of the transistor.

6. The method as claimed in any one of the preceding claims, wherein values of sustained voltage and corresponding current are also determined for other points on said characteristic.

7. The method as claimed in claim 2, wherein values of sustained voltage and corresponding current are also determined for other points on said characteristic said values including those for points on a tail portion of said characteristic, said values being determined for a transistor the base of which is reverse biassed, and the collector and emitter of which are connected across a clamp circuit, said clamp circuit being designed for inhibiting increase of voltage above a set voltage that is substantially higher than the breakdown point sustained voltage that is to be determined, accordingly to prevent premature breakdown occurring from a point of instability on said tail portion of the characteristic.

**Revendications**

1. Un procédé de mesure de valeurs de tension et de courant correspondant pour un transistor, ce transistor présentant une propriété d'auto-limitation de tension et ayant par conséquent une caractéristique de tension maintenue en fonction du courant, cette caractéristique descendant à partir d'un point de claquage final, en passant par un point de tension minimale, ce procédé comprenant les opérations suivantes :

on augmente le courant de collecteur jusqu'à une valeur élevée;

on augmente la tension collecteur-émetteur qui est imposée au transistor, jusqu'à ce qu'on atteigne une tension maintenue initiale sur la caractéristique, cette tension maintenue correspondant à un courant de valeur supérieure au courant qui correspond à une tension minimale; et

on accomplit de façon répétée les opérations d'augmentation de courant et de tension ci-dessus;

caractérisé en ce que :

on répète les opérations d'augmentation de courant et de tension précitées, en augmentant chaque fois le courant de collecteur jusqu'à une valeur plus élevée, jusqu'à ce que les valeurs de tension maintenue et de courant correspondant au point de claquage final soient déterminées, pour déterminer ainsi un paramètre de zone de fonctionnement de sécurité qui est donné par les valeurs précitées.

2. Le procédé de la revendication 1, dans lequel on répète les opérations d'augmentation de courant et de tension jusqu'à ce qu'un claquage se produise au point de claquage final.

3. Le procédé selon l'une quelconque des revendications précédentes, dans lequel on détermine les valeurs de tension maintenue et de courant correspondant au point de claquage final, pour un transistor dont la base est en circuit ouvert.

4. Le procédé selon l'une quelconque des revendications 1 ou 2, dans lequel on détermine les valeurs de tension maintenue et de courant correspondant au point de claquage final, pour un transistor dont la base est polarisée en inverse.

5. Le procédé selon la revendication 4, dans le cas où il est mis en oeuvre avec un circuit de fixation de niveau connecté entre le collecteur et l'émetteur du transistor.

6. Le procédé selon l'une quelconque des revendications précédentes, dans lequel on détermine également des valeurs de tension maintenue et de courant correspondant pour d'autres points sur la caractéristique.

7. Le procédé selon la revendication 2, dans lequel on détermine également des valeurs de tension maintenue et de courant correspondant pour d'autres points sur la caractéristique, ces valeurs comprenant celles qui correspondent à des points sur une partie de queue de la caractéristique, ces valeurs étant déterminées pour un transistor dont la base est polarisée en inverse, et dont le collecteur et l'émetteur sont connectés aux bornes d'un circuit de fixation de niveau, ce circuit de fixation de niveau étant conçu pour empêcher une augmentation de tension au-dessus d'une tension fixée qui est notablement supérieure à la tension maintenue de point de claquage qui doit être déterminée, pour empêcher ainsi l'apparition d'un claquage prématuré du fait d'un point d'instabilité sur la partie de queue de la caractéristique.

**Patentansprüche**

1. Verfahren zum Messen von Spannungs- und entsprechenden Stromwerten für einen Transistor, welcher Transistor eine Spannungsselbstbegrenzungseigenschaft zeigt und folglich eine Dauerspannungsstromkennlinie aufweist, wobei sich diese Kennlinie abwärts von einem letzten Durchbruchspunkt durch einen Punkt minimaler Spannung erstreckt, wobei das Verfahren die Schritte aufweist:
Anheben des Kollektorstromes auf einen erhöhten Wert;
Bewirken, daß sich die auf den Transistor aufgeprägte Kollektor-Emitter-Spannung erhöht, bis eine anfängliche Dauerspannung auf der Kennlinie erreicht ist, welche Dauerspannung einem Stromwert höher als ein einer Minimumsspannung entsprechender Strom entspricht, und wiederholtem Ausführen der obigen Schritte des Anhebens und Bewirkens, dadurch gekennzeichnet, daß
die Schritte des Anhebens und Bewirkens wiederholt werden, wobei jedesmal der Kollektorstrom auf einen höheren erhöhten Wert angehoben wird, bis die Werte der Dauerspannung und des entsprechenden Stromes an dem letzten Durchbruchspunkt so bestimmt werden, daß derart ein sicherer Betriebsbereichparameter durch die Werte gegeben wird.

2. Verfahren nach Anspruch 1, bei dem die Schritte des Anhebens und Bewirkens wiederholt werden, bis der Durchbruch an dem letzten Durchbruchspunkt auftritt.

3. Verfahren nach einem der vorhergehenden Ansprüche, bei dem die Werte der Dauerspannung und des entsprechenden Stromes an dem Durchbruchspunkt für einen Transistor bestimmt werden, dessen Basis offen ist.

4. Verfahren nach entweder Anspruch 1 oder 2, bei dem die Werte der Dauerspannung und des entsprechenden Stromes an dem letzten Durchbruchspunkt für einen Transistor bestimmt werden, dessen Basis rückwärts vorgespannt ist.

5. Verfahren nach Anspruch 4, wenn es mit einer zwischen dem Kollektor und dem Emitter des Transistors verbundenen Klemmschaltung ausgeführt wird.

6. Verfahren nach einem der vorhergehenden Ansprüche, bei dem die Werte der Dauerspannung und des entsprechenden Stromes auch für andere Punkte der Kennlinie bestimmt werden.

7. Verfahren nach Anspruch 2, bei dem Werte der Dauerspannung und des entsprechenden Stromes ebenfalls für andere Punkte auf der Kennlinie bestimmt werden, wobei die Werte jene Werte für Punkte auf einem Schwanzabschnitt der Kennlinie beinhalten, die Werte für einen Transistor bestimmt werden, dessen Basis rückwärts vorgespannt ist und dessen Kollektor und Emitter über eine Klemmschaltung verbunden sind, wobei die Klemmschaltung zum Verhindern des Ansteigens der Spannung über eine eingestellte Spannung ausgelegt ist, die wesentlich höher ist als die Durchbruchspunktdauerspannung, die zu bestimmen ist, damit verhindert wird, daß ein vorzeitiger Durchbruch von einem Instabilitätspunkt auf dem Schwanzabschnitt der Kennlinie auftritt.

## FIG.1

## FIG.2

SAFE OPERATING AREA

$I_C$

RATED $I_C$

1A

$V_{CE}$ →

MEASURED DATA OF $V_{CEO}(SUS)$

POINT OF MEASURMENT OF $V_{CEX}(SUS)$

MEASURED DATA OF $BV_{CBO}$

RATED VOLTAGE

## FIG.3

LOCUS OF $V_{CEX(SUS)}$   HORIZONTAL AXIS $V_{CE}$:200V/div

VERTICAL AXIS $I_C$:10A/div

## FIG.4

SAFE OPERATING AREA

$I_C$

RATED $I_C$

LOCUS OF $V_{CEO}(SUS)$

LOCUS OF $V_{CEX}(SUS)$

$V_{CE}$ ⟶

RATED VOLTAGE